# EUROPEAN PATENT APPLICATION

(11) **EP 4 495 985 A1**
(43) Date of publication of application: **22.01.2025**
(21) Application number: 24165725.3
(22) Date of filing: 24.03.2024
(51) Int. Cl.: H01L 21/768, H01L 23/48, H01L 29/78, H01L 23/528

(54) **SEMICONDUCTOR DEVICES**

(30) Priority: 20.07.2023 KR 20230094264
(71) Applicant: Samsung Electronics Co., Ltd., Suwon-si, Gyeonggi-do 16677 (KR)
(72) Inventor: KIM, Younghun, 16677 Suwon-si (KR)
(74) Representative: Marks & Clerk LLP

(57) **Abstract**

A semiconductor device includes an active pattern on a substrate, the active pattern extending in a first direction parallel to an upper surface of the substrate; a gate structure on the active pattern, the gate structure extending in a second direction parallel to the upper surface of the substrate and crossing the first direction; channels spaced apart from each other in a vertical direction, each of the channels extending through the gate structure; a through contact extending through the substrate and the active pattern in the vertical direction, an upper portion and a lower portion of the through contact connected to each other and formed of the same material; a lower wiring on a back side of the substrate, the lower wiring electrically connected to the through contact; and an upper wiring disposed on a front side of the substrate, the upper wiring electrically connected to the upper wiring.

## Description

### TECHNICAL FIELD

Example embodiments relate to semiconductor devices.

### DESCUSSION OF RELATED ART

In a semiconductor device, wirings that transmit electrical signals or supply power may be formed on a front side of the substrate. As semiconductor devices become more highly integrated, space to form the wirings on the front side of the substrate is becoming scarce.

### SUMMARY

Example embodiments provide a semiconductor device having enhanced characteristics.

According to example embodiments, there is provided a semiconductor device. The semiconductor device may include an active pattern on a substrate, the active pattern extending in a first direction parallel to an upper surface of the substrate; a gate structure on the active pattern, the gate structure extending in a second direction parallel to the upper surface of the substrate and crossing the first direction; channels spaced apart from each other in a vertical direction perpendicular to the upper surface of the substrate, each of the channels extending through the gate structure; a through contact extending through the substrate and the active pattern in the vertical direction, an upper portion and a lower portion of the through contact connected to each other and formed of the same material; a lower wiring on a back side of the substrate, the lower wiring electrically connected to the through contact; and an upper wiring disposed on a front side of the substrate, the upper wiring electrically connected to the through contact.

According to example embodiments, there is provided a semiconductor device. The semiconductor device may include an active pattern on a substrate, the active pattern extending in a first direction parallel to an upper surface of the substrate; a gate structure on the active pattern, the gate structure extending in a second direction parallel to the upper surface of the substrate and crossing the first direction; channels spaced apart from each other in a vertical direction perpendicular to the upper surface of the substrate, each of the channels extending through the gate structure; and a through contact extending through the substrate and the active pattern, the through contact including a lower portion and an upper portion sequentially arranged in the vertical direction; wherein a width in the second direction of the lower portion of the through contact decreases as the distance in the vertical direction from a lower surface of the substrate increases, and a width in the second direction of the upper portion of the through contact increases as the distance in the vertical direction from the lower surface of the substrate increases.

According to example embodiments, there is provided a semiconductor device. The semiconductor device may include an active pattern on a substrate, the active pattern extending in a first direction parallel to an upper surface of the substrate; a gate structure on the active pattern, the gate structure extending in a second direction parallel to the upper surface of the substrate and crossing the first direction; channels spaced apart from each other in a vertical direction perpendicular to the upper surface of the substrate, each of the channels extending through the gate structure; an insulating interlayer on the active pattern and the gate structure; and a through contact extending through the insulating interlayer and the substrate, the through contact commonly contacting sidewalls in the first direction of the channels, and an upper portion and a lower portion of the through contact contacting each other and having a same material.

In the semiconductor device, wirings that transmit electrical signals or supply power may be formed not only on a front side of the substrate but also on a back side of the substrate, and thus, there is additional space for forming the wiring. The wirings formed on the front side of the substrate and the wirings formed on the back side of the substrate may be electrically connected to each other by a through contact, and thus the degree of freedom of the layout of the wirings may increase.

Electrical signals or power may be transmitted by the through contact without passing a channel, and thus, a reduction in electrical signals or power may be alleviated. In addition, the through contact may be formed of a single material that does not include an interface between different materials, that is, the through contact may be formed integrally by a single material, and a decrease in electrical signals or power due to an increase in resistance between different materials may be additionally prevented.

However, the effects of the present invention are not limited thereto, and may be expanded in various ways without departing from the scope of the present invention.

At least some of the above and other features of the invention are set out in the claim.

### BRIEF DESCRIPTION OF THE DRAWINGS

FIGS. 1 to 4 are a plan view and cross-sectional views illustrating a semiconductor device according to example embodiments.
FIGS. 5 to 28 are plan views and cross-sectional views illustrating a method of manufacturing a semiconductor device according to example embodiments.
FIG. 29 is a cross-sectional view illustrating a semiconductor device according to example embodiments.
FIG. 30 is a cross-sectional view illustrating a semiconductor device according to example embodiments.
FIG. 31 is a cross-sectional view illustrating a method of manufacturing a semiconductor device according to example embodiments.
FIG. 32 is a cross-sectional view illustrating a semiconductor device according to example embodiments.

### DESCRIPTION OF EMBODIMENTS

A semiconductor device and a method of manufacturing the same in accordance with example embodiments will be described more fully with reference to plan views and/or cross-sectional views by way of ideal schematic views. Accordingly, the example views may be modified depending on manufacturing technologies and/or tolerances. Therefore, the disclosed embodiments are not limited to those shown in the views. Hereinafter in this specification (and not necessarily in the claims), two directions among horizontal directions substantially parallel to an upper surface of a substrate, which may cross each other, may be referred to as first and second directions D1 and D2, respectively, and a vertical direction substantially perpendicular to the upper surface of the substrate may be referred to as a third direction D3. In example embodiments, the first and second directions D1 and D2 may be substantially perpendicular to each other. The vertical direction (third direction D3) may define a height direction of the semiconductor device. Components or features that are described as "above" other comonents or features may be located further along the third direction D3 than the other components or features. Similarly, an upper portion of a component or feature may be a portion of the component or feature that is furthest along the third direction D3. It will be appreciated that these directions are defined relative to the structure of the semiconductor device and therefore do not necessarily limit the orientation of the semiconductor device in use.

Terms such as "same," "equal," "planar," "coplanar," "parallel," and "perpendicular," as used herein encompass identicality or near identicality including variations that may occur, for example, due to manufacturing processes. The term "substantially" may be used herein to emphasize this meaning, unless the context or other statements indicate otherwise.

Ordinal numbers such as "first," "second," "third," etc. may be used simply as labels of certain directions, elements, steps, etc., to distinguish such directions, elements, steps, etc. from one another. Terms that are not described using "first," "second," etc., in the specification, may still be referred to as "first" or "second" in a claim. In addition, a term that is referenced with a particular ordinal number (e.g., "first" in a particular claim) may be described elsewhere with a different ordinal number (e.g., "second" in the specification or another claim).

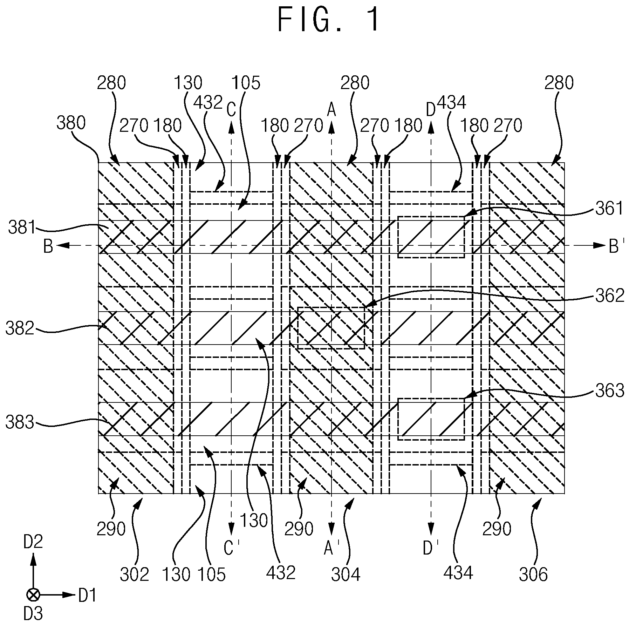

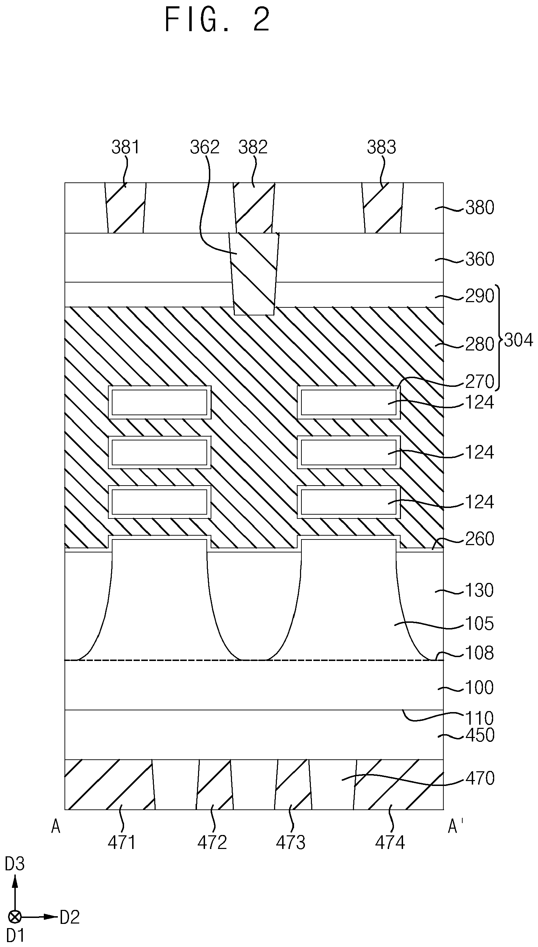

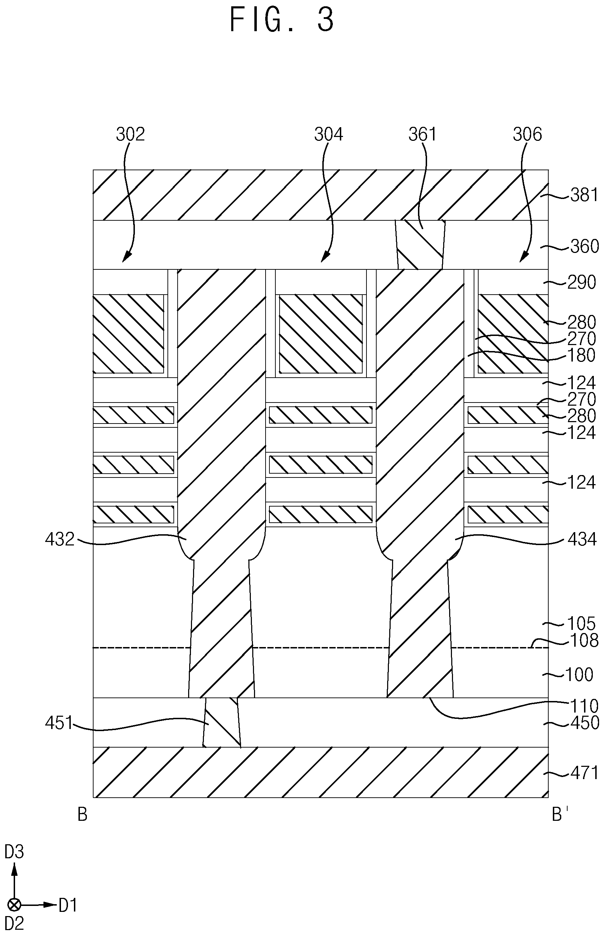

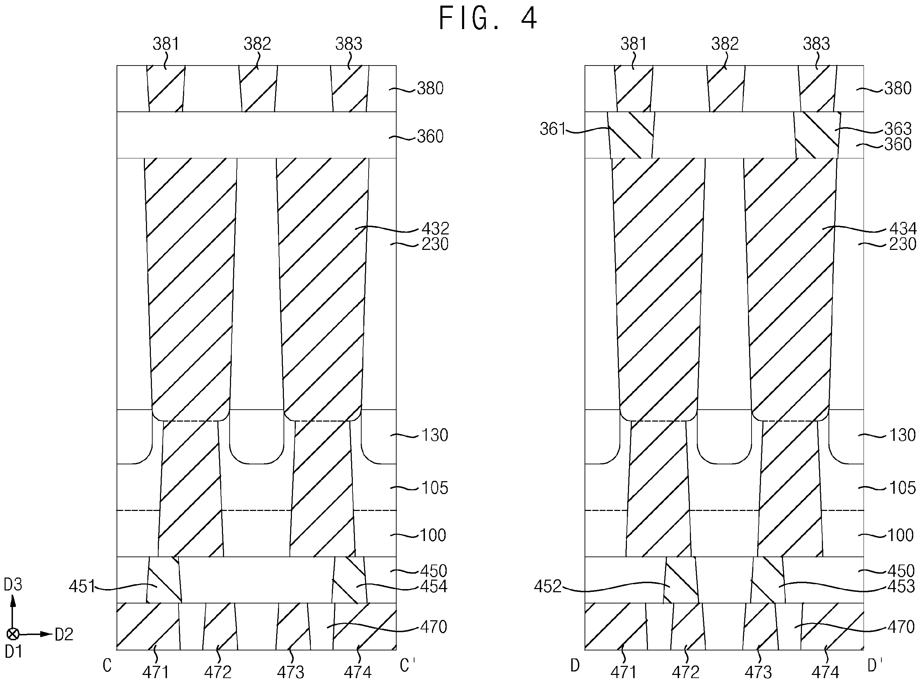

FIGS. 1 to 4 are a plan view and cross-sectional views illustrating a semiconductor device in accordance with example embodiments. FIG. 1 is the plan view, and FIGS. 2 to 4 are the cross-sectional views. FIG. 2 is a cross-sectional view taken along a line A-A' of FIG. 1, FIG. 3 is cross-sectional view taken along a line B-B' of FIG. 1, and FIG. 4 is a cross-sectional view taken along lines C-C' and D-D' of FIG. 1.

Referring to FIGS. 1 to 4, the semiconductor device may include an active pattern 105, an isolation pattern 130, a semiconductor pattern 124, a gate spacer 180, a gate structure (e.g., a first gate structure 302, a second gate structure 304, and/or a third gate structure 306), first to third upper vias 361, 362 and 363, first to third upper wirings 381, 382 and 383, a through contact (e.g., first through contact 432 and/or second through contact 434), first to fourth lower vias 451, 452, 453 and 454, first to fourth lower wirings 471, 472, 473 and 474, and first to fifth insulating interlayers 230, 360, 380, 450 and 470.

As used herein, the singular forms "a", "an", and "the" are intended to include the plural forms as well, unless the context clearly indicates otherwise. Additionally, the description may be specific to a portion of the semiconductor device and the described structure may be repeated in other portions of the semiconductor device. For example, the described structure may be an individual element of an array of elements forming the semiconductor device. Accordingly, where the structure of a single element of a plurality of elements has been described, this structure may equally apply to other elements of the plurality of elements.

The substrate 100 may be formed of and/or include a semiconductor material, e.g., silicon, germanium, silicon-germanium, etc., or III-V semiconductor compounds, e.g., GaP, GaAs, GaSb, etc. In some embodiments, the substrate 100 may be formed of and/or include a silicon-on-insulator (SOI) substrate or a germanium-on-insulator (GOI) substrate.

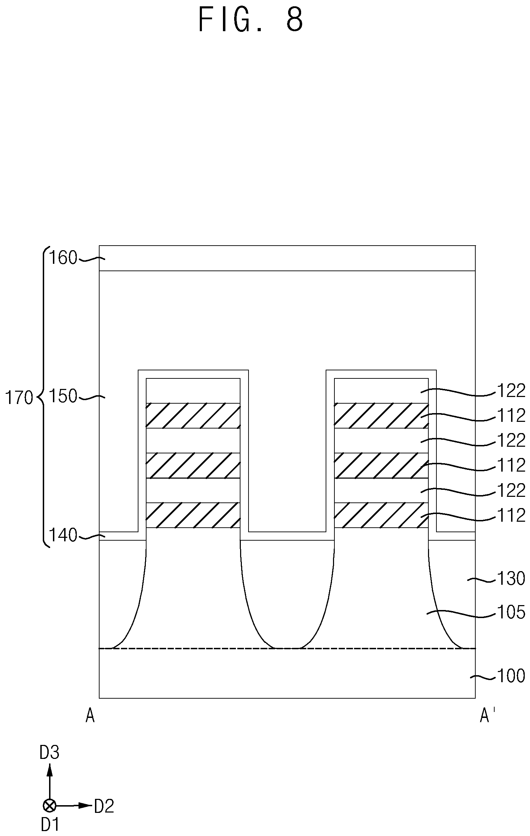

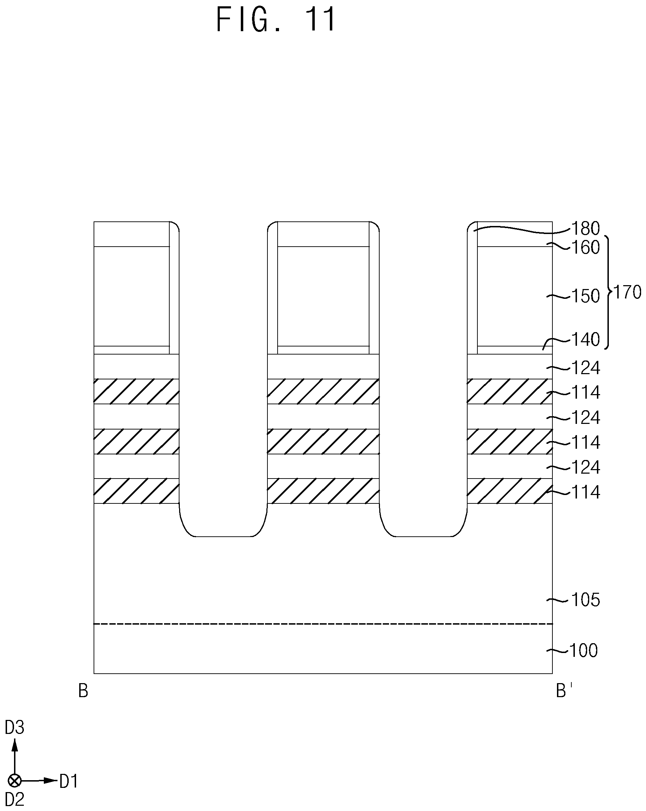

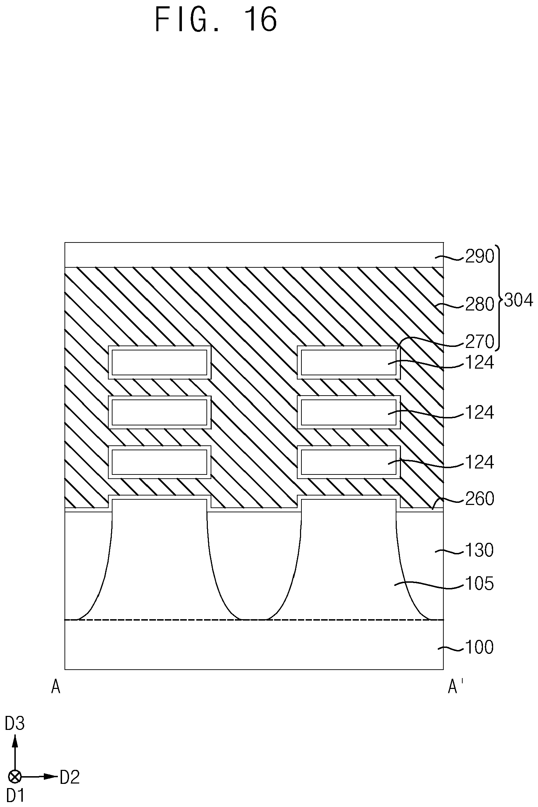

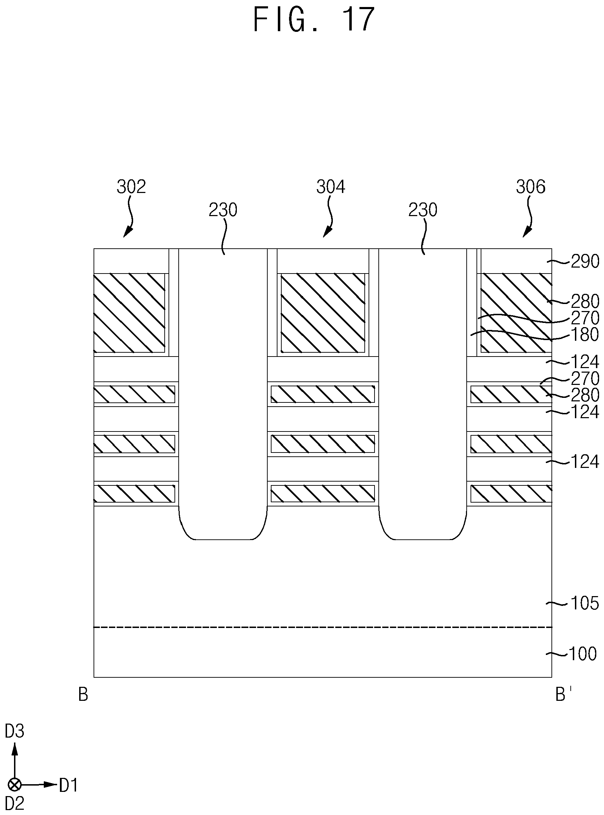

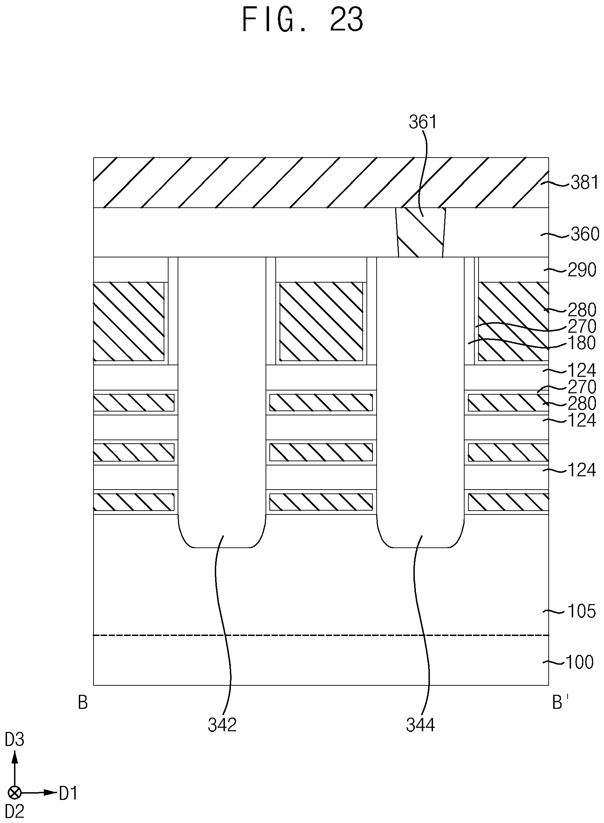

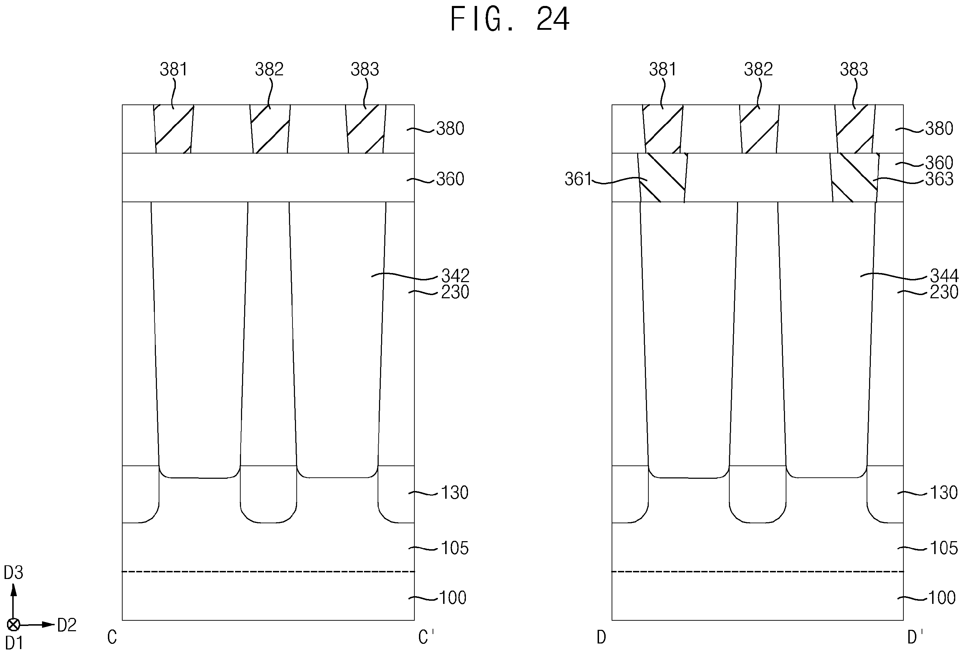

The active pattern 105 may protrude from an upper surface of the substrate 100, and a sidewall of the active pattern 105 may be covered by the isolation pattern 130. The upper surface of the substrate 100, as viewed in FIGS. 1-24 and 29-32, may be referred to as a front surface 108 and a lower surface of the substrate 100, as viewed in FIGS. 1-24 and 29-32, may be referred to as a back surface 110. The upper surface of the substrate 100 may be a surface facing in the third direction D3. The lower surface of the substrate 100 may be a surface facing in a direction opposite to the third direction D3. The lower surface of the substrate 100 may be opposite to the upper surface of the substrate 100.

In example embodiments, the active pattern 105 may extend in the first direction D1, and a plurality of active patterns 105 may be spaced apart from each other in the second direction D2.

In example embodiments, the isolation pattern 130 may extend in the first direction D1 between two active patterns 105 adjacent to each other in the second direction D2, and a plurality of isolation patterns 130 may be spaced apart from each other in the second direction D2.

The active pattern 105 may be formed of and/or include a material substantially the same as that of the substrate 100, and the isolation pattern 130 may be formed of and/or include an oxide, e.g., silicon oxide.

The semiconductor patterns 124 may be formed at a plurality of levels, respectively, which are spaced apart from each other in the third direction D3, and each of the semiconductor patterns 124 may extend in the first direction D1 to a given length. FIGS. 2 and 3 show that the semiconductor patterns 124 are formed at three levels, respectively, however, the inventive concept is not limited thereto.

FIG. 3 shows that each level has two semiconductor patterns 124 spaced apart from each other on the active pattern 105 extending in the first direction D1, however, the inventive concept may not be limited thereto, and each level may have more than two semiconductor patterns 124 spaced apart from each other at each level on the active pattern 105.

In example embodiments, the semiconductor pattern 124 may be a nanosheet or nanowire formed of and/or including a semiconductor material, e.g., silicon, germanium, etc. A nanosheet may be a structure having a thickness in at least one direction that falls within the range of 1nm - 100 nm. A nanowire may be a structure having thicknesses in at least two directions that fall within the range of 1-100 nm. In example embodiments, the semiconductor pattern 124 may serve as a channel in a transistor, and thus may also be referred to as a channel.

The gate structure may extend in the second direction D2 on the active pattern 105 and the isolation pattern 130, and a plurality of gate structures may be spaced apart from each other in the first direction D1. Hereinafter, the gate structures in FIG. 1 may be referred to as first to third gate structures 302, 304 and 306, respectively, from the left along the first direction D1 as shown in FIG. 1.

In example embodiments, the gate structure may surround a central portion in the first direction D1 of each of the semiconductor patterns 124 and may cover lower and upper surfaces and opposite sidewalls in the second direction D2 of the central portion of each of the semiconductor patterns 124.

The gate structure may include a gate insulation pattern 270, a gate electrode 280, and a capping pattern 290. In example embodiments, the gate insulation pattern 270 may be formed on a surface of each of the semiconductor patterns 124, an upper surface of the active pattern 105, an upper surface of the isolation pattern 130, a sidewall of the through contact, and an inner sidewall of the gate spacer 180. The gate electrode 280 may fill a space between semiconductor patterns 124 that are spaced apart from each other in the third direction D3, a space between the active pattern 105 and a lowermost one of the semiconductor patterns 124, and a space between the gate spacers 180 that are spaced apart from each other in the first direction D1 on an uppermost one of the semiconductor patterns 124. The capping pattern 290 may contact upper surfaces of the gate insulating pattern 270 and the gate electrode 280, and may contact the inner sidewall of the gate spacer 180.

Hereinafter, a portion of the gate structure on the uppermost one of the semiconductor patterns 124 may be referred to as an upper portion of the gate structure, and other portions of the gate structure under the upper portion may be referred to as a lower portion of the gate structure.

The gate insulation pattern 270 may be formed of and/or include an oxide, e.g., silicon oxide. The gate electrode 280 may be formed of and/or include a metal nitride, e.g., titanium nitride, titanium aluminum nitride, tantalum nitride, tantalum aluminum nitride, etc., a metal alloy, e.g., titanium aluminum, titanium aluminum carbide, titanium aluminum oxynitride, titanium aluminum carbonitride, titanium aluminum oxycarbonitride, etc., a metal carbide, a metal oxynitride, a metal carbonitride, a metal oxycarbonitride, or a low resistance metal, e.g., tungsten, aluminum, copper, tantalum. The capping pattern 290 may be formed of and/or include an insulating nitride, e.g., silicon nitride.

The gate spacer 180 may be formed on each of opposite sidewalls in the first direction D1 of the gate structure. The gate spacer 180 may be formed of and/or include an insulating nitride, e.g., silicon nitride, or an oxide, e.g., silicon oxide.

The through contact may extend through the first insulating interlayer 230 and the substrate 100 in the vertical direction. In example embodiments, a plurality of through contacts may be spaced apart from each other in the second direction D2 between two gate structures that are adjacent to each other in the first direction D1. Two through contacts may be formed between the two gate structures that are adjacent to each other in the first direction D1, however, the inventive concept may not be limited thereto.

Hereinafter, the through contact between the first gate structure 302 and the second gate structure 304 may be referred to as a first through contact 432, and the through contact between the second gate structure 304 and the third gate structure 306 may be referred to as a second through contact 434.

The through contact may contact sidewalls in the first direction D1 of the gate spacer 180, the semiconductor pattern 124, and the lower portion of the gate structure. As the through contact may contact the sidewall of the semiconductor pattern 124 in the first direction D1, the through contact may serve as a source or drain (source/drain). Each sidewall of the semiconductor pattern 124 that contacts the through contact may run along a plane that intersects (e.g. is perpendicular to) the first direction D1.

A lower surface of the through contact may be substantially coplanar with a lower surface (i.e., the back surface 110) of the substrate 100, and an upper surface of the through contact may be substantially coplanar with an upper surface of the first insulating interlayer 230, but the inventive concept may not be limited thereto. That is, in some embodiments, the lower surface of the through contact may be lower than the lower surface of the substrate 100, or the upper surface of the through contact may be higher than the upper surface of the first insulating interlayer 230.

In example embodiments, the through contact may include a lower portion and an upper portion sequentially stacked in the third direction D3. The lower portion may be a portion disposed between adjacent active patterns 105 and the upper portion may be a portion disposed above the lower portion. A width in the second direction D2 of the lower portion of the through contact may gradually decrease as the distance from the lower surface (i.e., back surface 110) of the substrate 100 increases (e.g., the lower portion may be identified as the portion in which the width decreases as the distance from the lower surface of the substrate 100 increases), and a width in the second direction D2 of the upper portion of the through contact may gradually increase as the distance from the lower surface (i.e., the back surface 110) of the substrate 100 increases (e.g., the upper portion may be identified as the portion in which the width increases as the distance from the lower surface of the substrate 100 increases). The upper portion may be located further along the third direction D3 (e.g. further from the lower surface of the substrate 100) than the lower portion.

An area of an upper cross section of the lower portion of the through contact may be smaller than an area of a lower cross section of the upper portion of the through contact near a transition from the lower portion to the upper portion, but the inventive concept may not be limited thereto. That is, the area of the upper cross section of the lower portion of the through contact may be substantially the same as the area of the lower cross section of the upper portion of the through contact near a transition from the lower portion to the upper portion, or alternatively, the area of the upper cross section of the lower portion of the through contact may be greater than the area of the lower cross section of the upper portion of the through contact near a transition from the lower portion to the upper portion.

In an example embodiment, the first through contact 432 may serve as a source and the second through contact 434 may serve as a drain. Alternatively, the first through contact 432 may serve as a drain, and the second through contact 434 may serve as a source.

In example embodiments, the through contact may be formed of and/or include a single material and be integrally formed. For example, the through contact may be a continuously integrated structure, without a discontinuous boundary surface (for example, a grain boundary), in which two components formed by a different process are not simply in contact (discontinuity), but are formed of the same material by the same process. In some examples, the through contact may not include an interface between different materials since the upper portion and the lower portion include the same material and/or are formed by the same process.

In example embodiments, the through contact may be formed of and/or include a conductive material, for example, a metal, a metal nitride, etc.

The first insulating interlayer 230 may be formed on the active pattern 105 and the isolation pattern 130. The second insulating interlayer 360 may be formed on the first insulating interlayer 230, the capping pattern 290, the gate spacer 180 and the through contact. The third insulating interlayer 330 may be formed on the second insulating interlayer 360 and the first to third upper vias 361, 362 and 363.

The fourth insulating interlayer 450 may be formed below the lower surface (i.e., back surface 110) of the substrate 100 and may cover at least a portion of the lower surface of the through contact. The fifth insulating interlayer 470 may be formed below the fourth insulating interlayer 450 to cover at least a portion of the lower surfaces of the first to fourth lower vias 451, 452, 453 and 454.

Each of the first to fifth insulating interlayers 230, 360, 380, 450 and 470 may be formed of and/or include an insulating material, e.g., silicon oxycarbide (SiOC), silicon oxide (SiO₂), silicon nitride (SiN), silicon oxynitride (SiON), silicon carbonitride (SiCN), silicon oxycarbonitride (SiOCN), etc.

Each of the first and third upper vias 361 and 363 may extend through the second insulating interlayer 360 to contact an upper surface of the second through contact 434 which may serve as, for example, a drain. The second upper via 362 may extend though the second insulating interlayer 360 and the capping pattern 290 to contact an upper surface of the gate electrode 280.

The first to third upper wirings 381, 382 and 383 may extend through the third insulating interlayer 380 to contact upper surfaces of the first to third upper vias 361, 362 and 363, respectively. In example embodiments, each of the first to third upper wirings 381, 382 and 383 may extend in the first direction D 1.

Each of the first and fourth lower vias 451 and 454 may extend through the fourth insulating interlayer 450 to contact the lower surface of the first through contact 432 which may serve as, for example, a source. Each of the second and third lower vias 452 and 453 may extend though the fourth insulating interlayer 450 to contact the lower surface of the second through contact 434 which may serve as, for example, a drain.

The first to fourth lower wirings 471, 472, 473 and 474 may extend through the fifth insulating interlayer 470 to contact lower surfaces of the first to fourth lower vias 451, 452, 453 and 454, respectively. In example embodiments, each of the first to fourth lower wirings 471, 472, 473, and 474 may extend in the first direction D1.

In example embodiments, each of the first and fourth lower wirings 471 and 474 may serve as a power rail that supplies power, and each of the second and third lower wirings 472 and 473 may serve as a signal line that transmits electrical signals. Accordingly, a width in the second direction D2 of each of the first and fourth lower wirings 471 and 474 may be greater than a width in the second direction D2 of each of the second and third lower wirings 472 and 473.

Each of the first to third upper vias 361, 362, and 363, the first to third upper wirings 381, 382, and 383, the first to fourth lower vias 451, 452, 453, and 454, and the first to fourth lower wirings 471, 472, 473, and 474 may include a conductive pattern and a barrier pattern covering a lower surface and a sidewall thereof. The conductive pattern may be formed of and/or include a metal such as tungsten, cobalt, molybdenum, etc., and the barrier pattern may be formed of and/or include a metal nitride such as titanium nitride, tantalum nitride, tungsten nitride, etc.

The semiconductor device may be a multi-bridge channel field effect transistor (MBCFET) including the semiconductor patterns 124 that are spaced apart from each other in the third direction D3 and serve as channels, respectively.

In the semiconductor device, power may be supplied by the first lower wiring 471, and current may flow from the first through contact 432 to the second through contact 434 through the semiconductor patterns 124. Electrical signals may be transferred to a desired location either: 1) from the second through contact 434 to the first upper via 361 and the first upper wiring 381 or the third upper via 363 and the third upper wiring 383 at the front side of the substrate 100, or 2) from the second through contact 434 to the second lower via 452 and the second lower wiring 472 or the third lower via 453 and the third lower wiring 473 at the back side of the substrate 100. That is, as the through contact electrically connects wirings on each of the front and back sides of the substrate 100, wirings may be designed more freely since they may be located on either front or back side of the substrate 100.

It will be understood that when an element is referred to as being "connected" or "coupled" to or "on" another element, it can be directly connected or coupled to or on the other element or intervening elements may be present. In contrast, when an element is referred to as being "directly connected" or "directly coupled" to another element, or as "contacting" or "in contact with" another element (or using any form of the word "contact"), there are no intervening elements present at the point of contact.

As used herein, elements described as being "electrically connected" are configured such that an electrical signal can be transferred from one element to the other (although such electrical signal may be attenuated in strength as it is transferred and may be selectively transferred). Moreover, elements that are "directly electrically connected" share a common electrical node through electrical connections by one or more conductors, such as, for example, wires, pads, internal electrical lines, through vias, etc. As such, directly electrically connected elements do not include elements electrically connected through active elements, such as transistors or diodes.

In addition, the through contact may include a single material that is integrally formed, and thus, power loss due to interfacial resistance that occurs between different materials may be minimized. Additionally, electrical signals transmitted by one of the through contacts may be transmitted to the front or back side of the substrate by another of the through contacts, vias, or wirings without passing through the semiconductor pattern 124, and thus, power loss that occurs when electrical signals pass through the semiconductor pattern 124 may also be minimized.

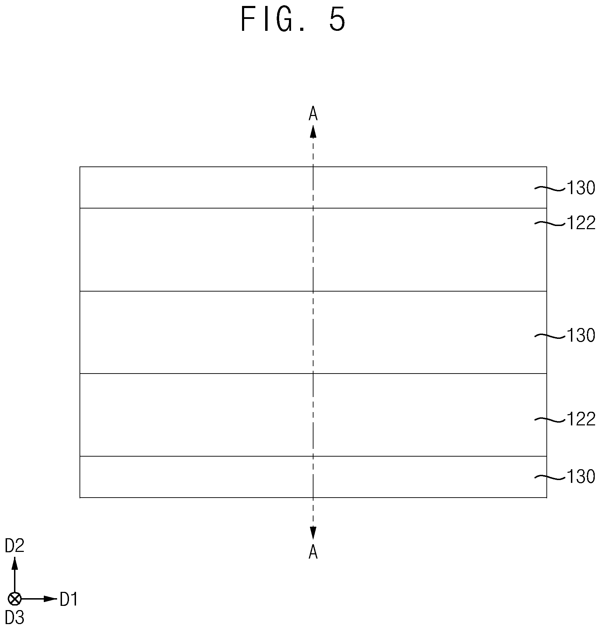

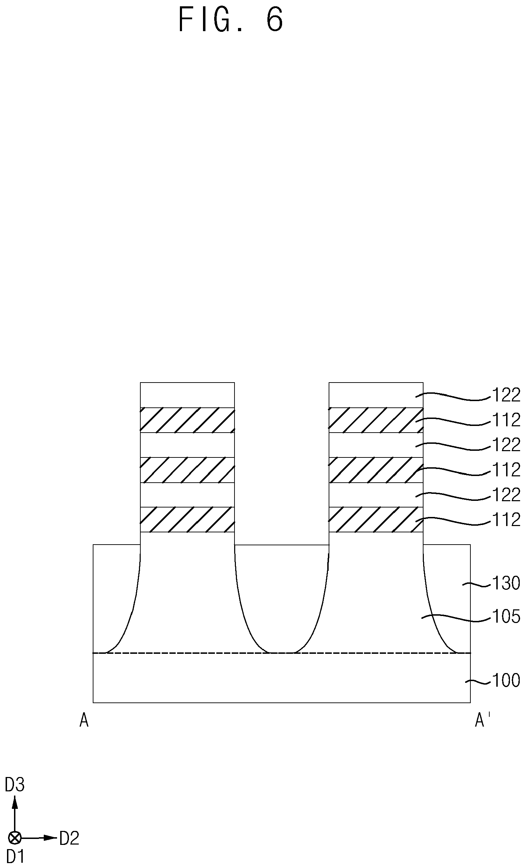

FIGS. 5 to 28 are plan views and cross-sectional views illustrating a method of manufacturing a semiconductor device in accordance with example embodiments. Particularly, FIGS. 5, 7, 10, and 15 are the plan views and FIGS. 6, 8-9, 11-14, and 16-28 are cross-sectional views.

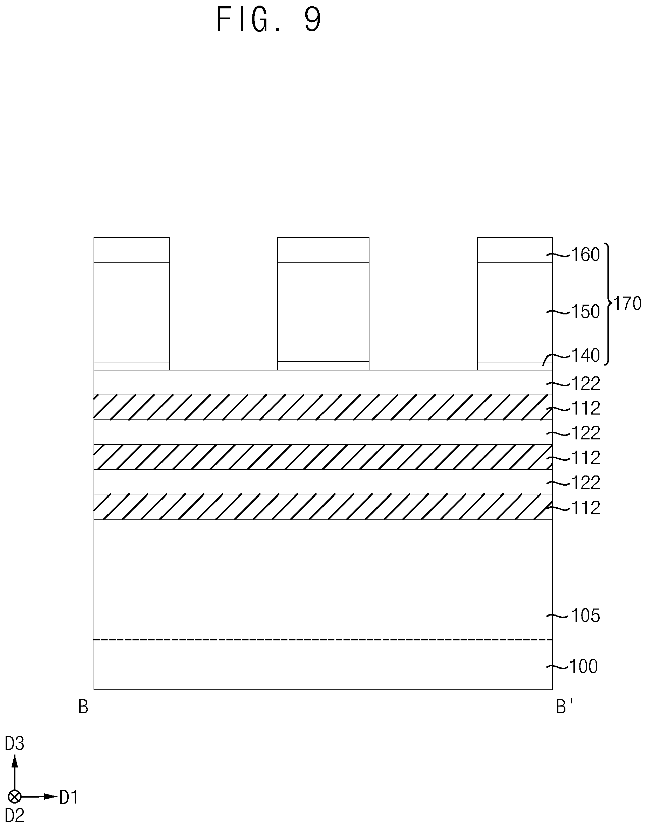

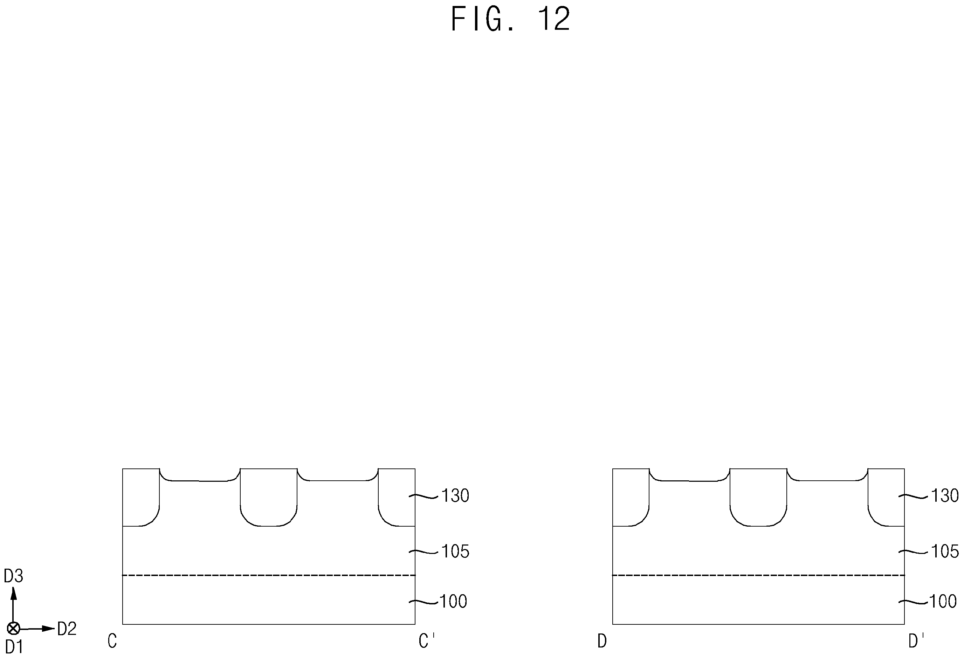

FIGS. 6, 8, 16, 22, and 25 are cross-sectional views taken along lines A-A' of corresponding plan views, respectively, FIGS. 9, 11, 13, 17-18, 20, 23, and 27 are cross-sectional views taken along lines B-B' of corresponding plan views, respectively, and FIG. 12, 14, 19, 21, 24, 26, and 28 are cross-sectional views taken along line C-C' and D'-D' of corresponding plan views, respectively.

Referring to FIGS. 5 to 6, a sacrificial layer and a semiconductor layer may be alternately and repeatedly stacked on a substrate 100, a first etching mask extending in the first direction D1 may be formed on an uppermost one of the semiconductor layers, and the semiconductor layers, the sacrificial layers, and an upper portion of the substrate 100 may be etched using the first etching mask to form a structure such as that shown in FIGS. 5 and 6 (which may exclude the isolation pattern 130 which may be added after the etching process).

Thus, an active pattern 105 extending in the first direction D1 may be formed on the substrate 100, and a fin structure including sacrificial lines 112 and semiconductor lines 122 alternately and repeatedly stacked in the third direction D3 may be formed on the active pattern 105. In example embodiments, the fin structure may extend in the first direction D1 on the substrate 100, and a plurality of fin structures may be spaced apart from each other in the second direction D2 on the substrate 100.

FIG. 6 shows three sacrificial lines 112 and three semiconductor lines 122 at four levels, respectively. However, the inventive concept may not be limited thereto. The semiconductor lines 122 may be formed of and/or include a semiconductor material such as silicon, and the sacrificial lines 112 may include a material having an etching selectivity with respect to the substrate 100 and the semiconductor lines 122. For example, the sacrificial lines 112 may be formed of silicon-germanium.

An isolation pattern 130 may be formed on the substrate 100 to cover at least a portion of the sidewall of the active pattern 105.

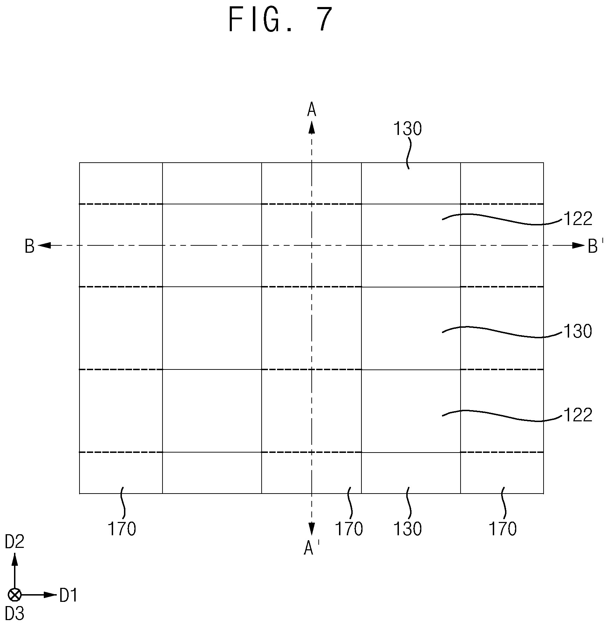

Referring to FIGS. 7 to 9, a dummy gate insulation layer, a dummy gate electrode layer, and a dummy gate mask layer may be sequentially formed on the active pattern 105, the fin structures and the isolation pattern 130. A second etching mask extending in the second direction D2 may be formed on the dummy gate mask layer, and the dummy gate mask layer may be etched using the second etching mask to form a dummy gate mask 160.

The dummy gate electrode layer and the dummy gate insulation layer may be etched using the dummy gate mask 160 as an etching mask to form a dummy gate electrode 150 and a dummy gate insulation pattern 140, respectively.

The dummy gate insulation pattern 140, the dummy gate electrode 150, and the dummy gate mask 160 that are sequentially stacked in the third direction D3 on the active pattern 105 and a portion of the isolation pattern 130 adjacent thereto may form a dummy gate structure 170.

In example embodiments, the dummy gate structure 170 may extend in the second direction D2 on the fin structure and the isolation pattern 130, and may cover an upper surface and opposite sidewalls in the second direction D2 of the fin structure.

In example embodiments, a plurality of dummy gate structures 170 may be spaced apart from each other in the first direction D 1.

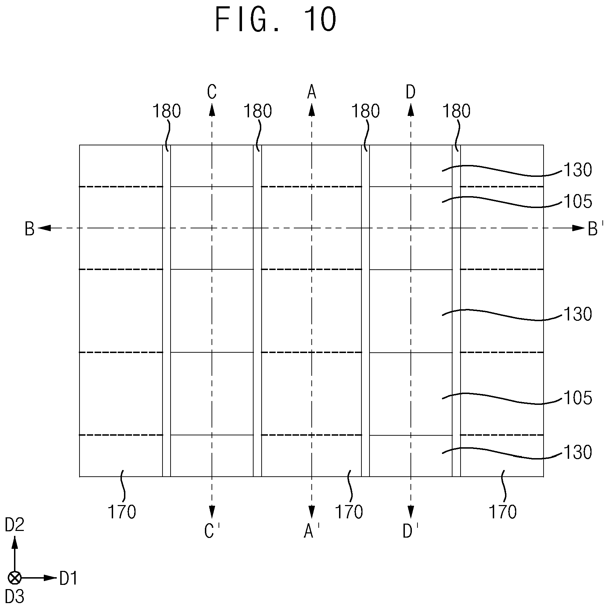

Referring to FIGS. 10 to 12, a gate spacer 180 may be formed on a sidewall of the dummy gate structure 170.

Particularly, a spacer layer may be formed on the fin structure, the isolation pattern 130, and the dummy gate structure 170, and the spacer layer may be anisotropically etched to form the gate spacer 180 on each of opposite sidewalls in the first direction D1 of the dummy gate structure 170.

The fin structure and an upper portion of the active pattern may be etched using the dummy gate structure 170 and the gate spacer 180 as an etching mask.

Thus, the sacrificial lines 112 and the semiconductor lines 122 under the dummy gate structure 170 and the gate spacers 180 may be modified to become sacrificial patterns 114 and semiconductor patterns 124, respectively, and the fin structure extending in the first direction D1 may be divided into a plurality of parts spaced apart from each other in the first direction D 1.

Hereinafter, the dummy gate structure 170, the gate spacers 180 on the opposite sidewalls, respectively, of the dummy gate structure 170, and the fin structure may be referred to as a stack structure. In example embodiments, the stack structure may extend in the second direction D2, and a plurality of stack structures may be spaced apart from each other in the first direction D1.

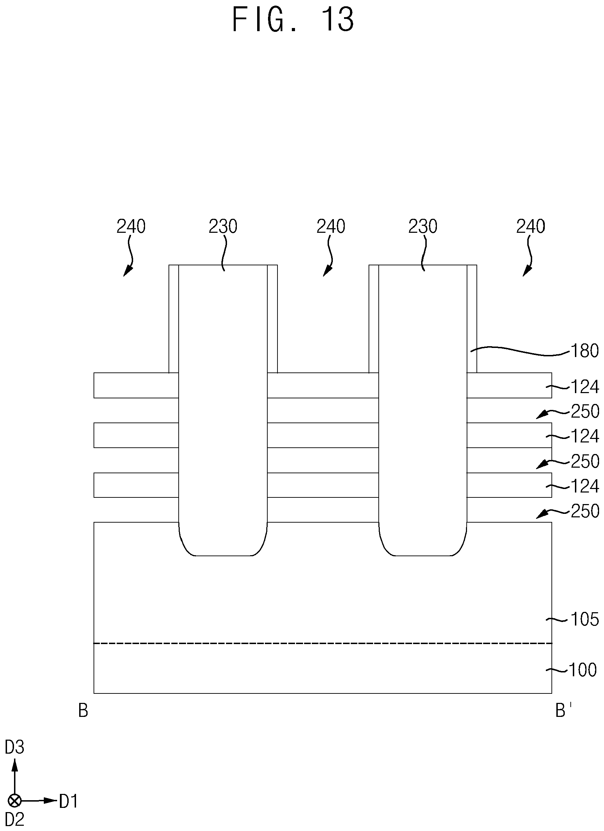

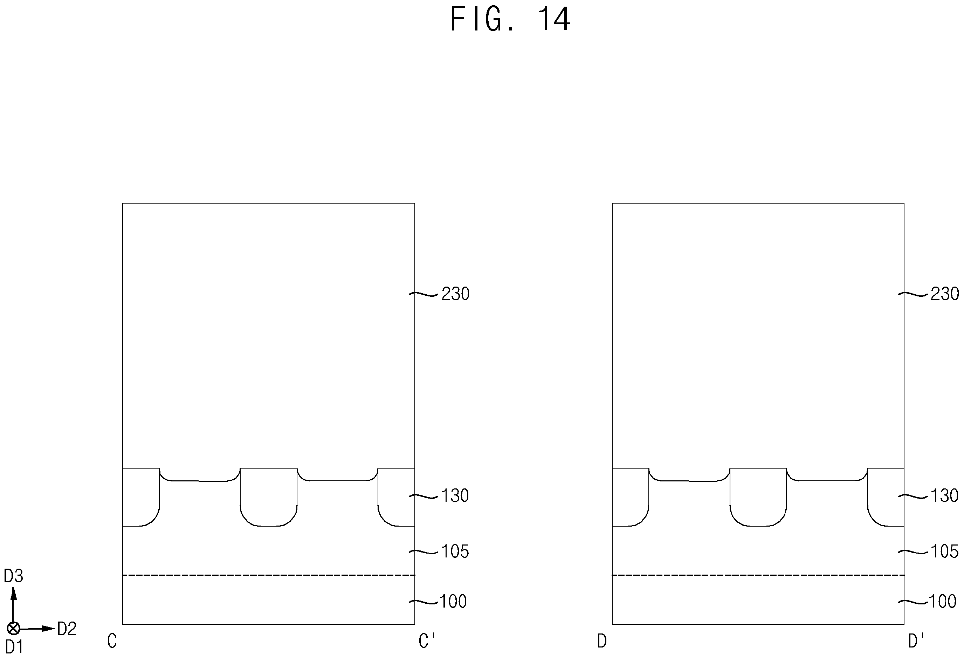

Referring to FIGS. 13 and 14, a first insulating interlayer 230 may be formed on an upper surface of the active pattern 105, an upper surface of the isolation pattern 130, and a sidewall and an upper surface of the stack structure.

A planarization process may be performed until an upper surface of the dummy gate electrode 150 is exposed, and thus, an upper portion of the first insulating interlayer 230 and the dummy gate mask 160 of the dummy gate structure 170 may be removed by the planarization process.

The exposed dummy gate electrode 150, the dummy gate insulation pattern 140 below the dummy gate electrode 150, and the sacrificial pattern 114 may be removed by an etching process such as a wet etching process and/or a dry etching process.

Accordingly, a first opening 240 exposing an inner sidewall of the gate spacer 180 and an upper surface of an uppermost one of the semiconductor patterns 124, and a second opening 250 exposing surfaces of the semiconductor patterns 124 and the upper surface of the active pattern 105 may be formed.

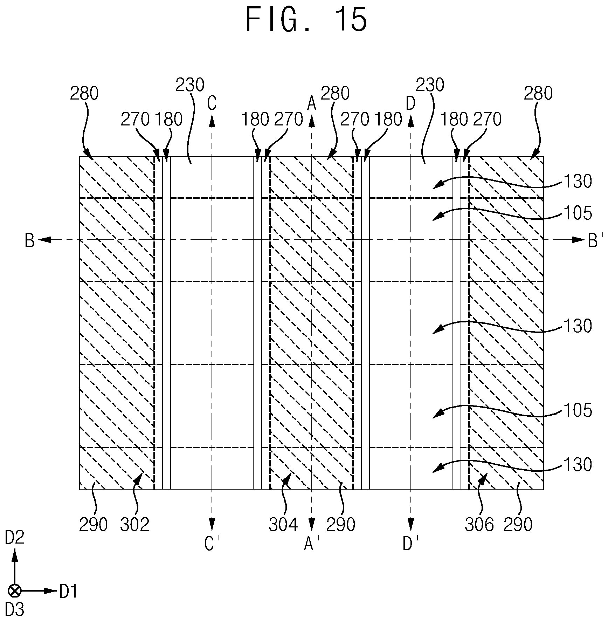

Referring to FIGS. 15 to 17, a gate insulation layer may be formed on the inner sidewall of the gate spacer 180, the surfaces of the semiconductor patterns 124, the upper surface of the active pattern 105 and the upper surface of the isolation pattern 130 exposed by the first and second openings 240 and 250, and the upper surface of the first insulating interlayer 230, and a gate electrode layer may be formed on the gate insulation layer to fill remaining portions of the first and second openings 240 and 250.

In an example embodiment, an interface pattern formed of and/or including a material such as silicon oxide may be further formed on the upper surface of the active pattern 105 and the surfaces of the semiconductor patterns 124.

The gate electrode layer and the gate insulation layer may be planarized until the upper surface of the first insulating interlayer 230 is exposed. Thus, a gate insulation pattern 270 and a gate electrode 280 may be formed in the first and second openings 240 and 250. Upper portions of the gate insulation pattern 270 and the gate electrode 280 may be removed to form a recess, and a capping pattern 290 may be formed in the recess. The gate insulation pattern 270, the gate electrode 280, and the capping pattern 290 may collectively form a gate structure.

Hereinafter, the gate structures disposed in the first direction D1 may be referred to as first to third gate structures 302, 304 and 306, respectively, from the left along the first direction D1.

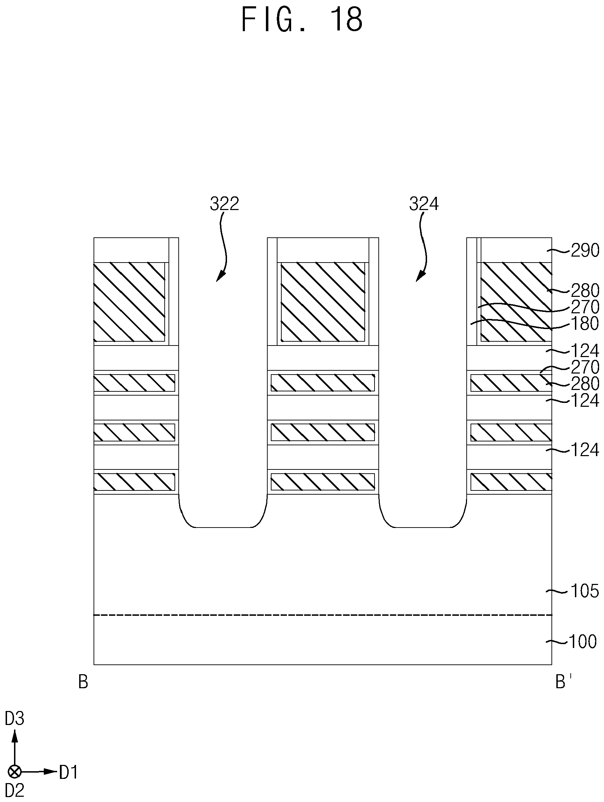

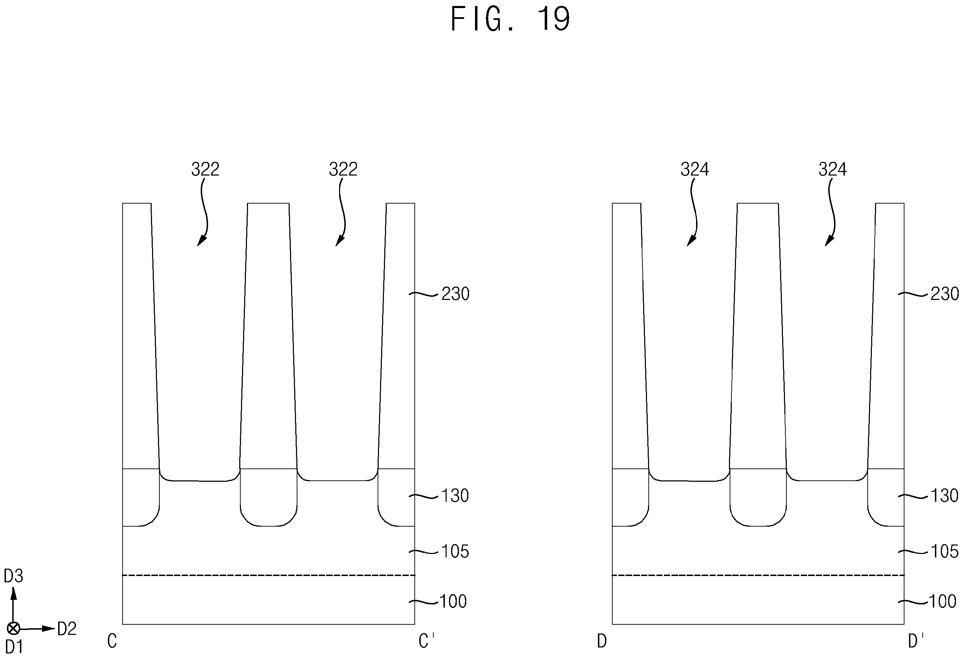

Referring to FIGS. 18 and 19, a third opening 322 extending through the first insulating interlayer 230 may be formed to expose the upper surface of the active pattern 105 between the first and second gate structures 302 and 304 adjacent to each other in the first direction D1, and a fourth opening 324 extending through the first insulating interlayer 230 may be formed to expose the upper surface of the active pattern 105 between the second and third gate structures 304 and 306.

The third and fourth openings 322 and 324 may not expose the isolation pattern 130, however, the inventive concept may not be limited thereto. That is, the upper surface of the isolation pattern 130 may be partially exposed by the third and/or fourth openings 322 and 324.

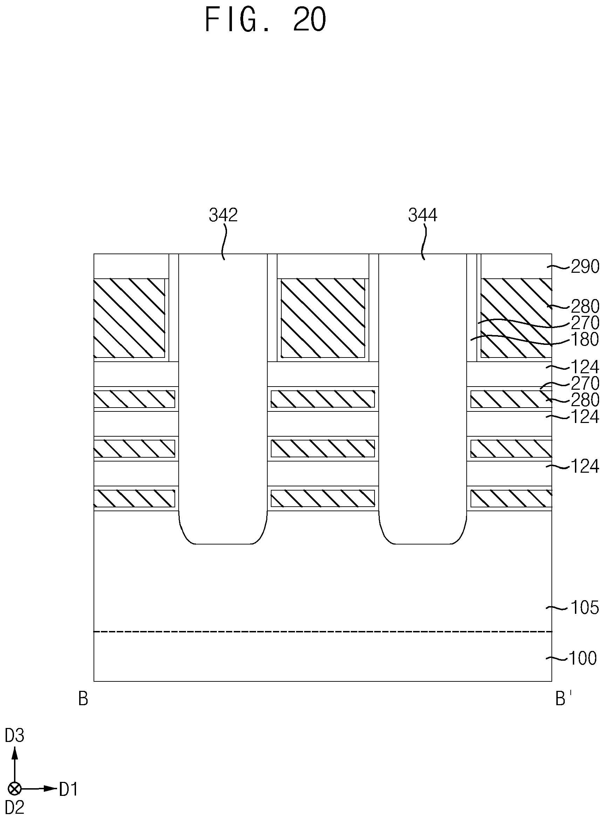

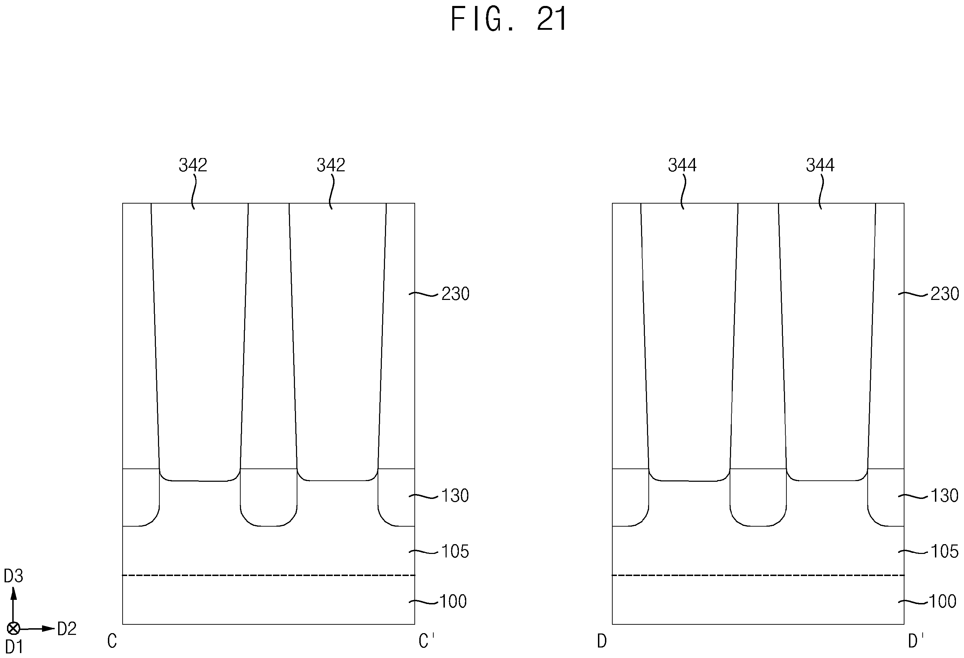

Referring to FIGS. 20 and 21, first and second sacrificial patterns 342 and 344 may be formed in the third and fourth openings 322 and 324, respectively.

In example embodiments, the first and second sacrificial patterns 342 and 344 may be formed by forming a sacrificial layer to fill the third and fourth openings 322 and 324 to a sufficient height and planarizing an upper portion to expose an upper surface of the capping pattern 290.

In example embodiments, the first and second sacrificial patterns 342 and 344 may be formed of and/or include a material having an etch selectivity with respect to materials of the substrate 100, the semiconductor pattern 124, the gate spacer 180, and the gate insulating pattern 270.

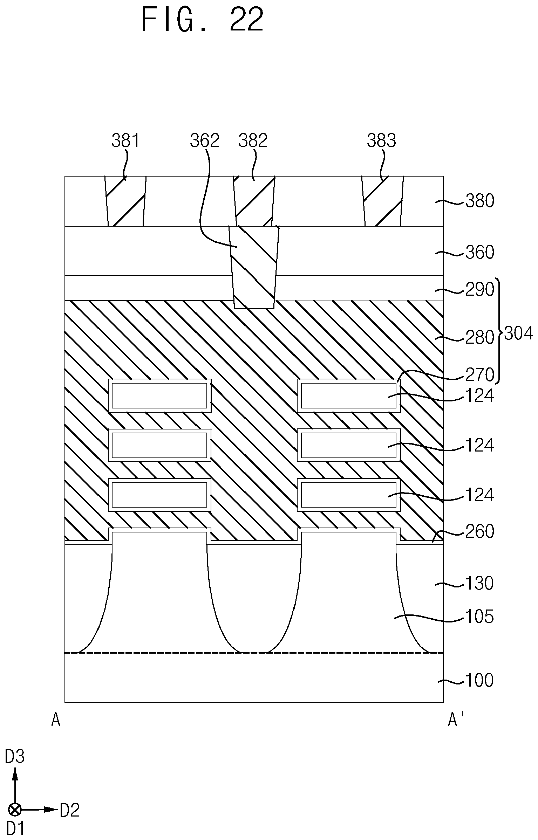

Referring to FIGS. 22 to 24, the second insulating interlayer 360 may be formed on the first insulating interlayer 230, the capping pattern 290, and the first and second sacrificial patterns 342 and 344. The first and third upper vias 361 and 363 extending through the second insulating interlayer 360 may be formed to contact an upper surface of the second sacrificial pattern 344. A second upper via 362 extending through the second insulating interlayer 360 and the capping pattern 290 may be formed to contact an upper surface of the gate electrode 280.

The third insulating interlayer 380 may be formed on the first to third upper vias 361, 362 and 363 and the second insulating interlayer 360. First to third upper wirings 381, 382 and 383 extending through the third insulating interlayer 380 may be formed to contact upper surfaces of the first to third upper vias 361, 362 and 363, respectively.

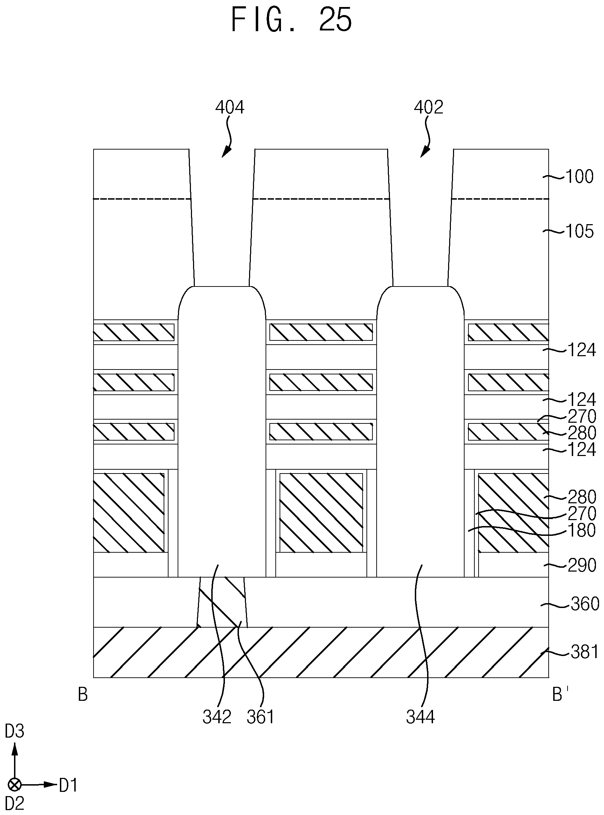

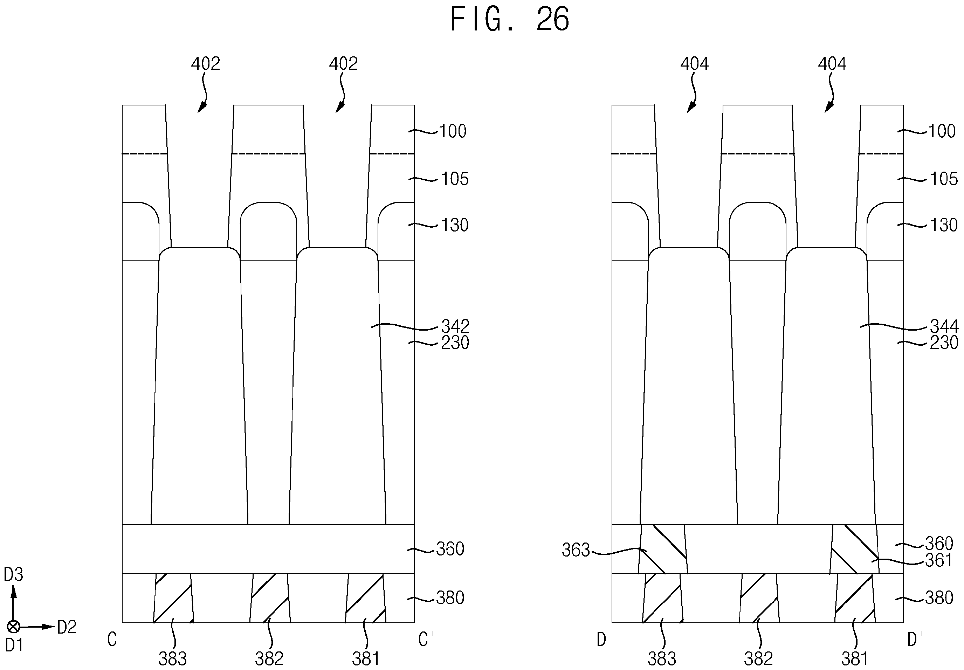

Referring to FIGS. 25 and 26, the substrate 100 may be rotated by 180 degrees (i.e., inverted) such that the front surface 108 faces downward and is a lower surface of the substrate 100, and the back surface 110 faces upward and is an upper surface of the substrate 100. A planarization process may be performed on the upper surface of the substrate 100 (e.g., the back surface 110).

Referring to FIGS 25 through 28, upper and lower may be defined based on the substrate 100 rotated by 180 degrees (e.g., as the substrate appears in FIG. 25).

Fifth and sixth openings 402 and 404 extending through the substrate 100 may be formed to expose upper surfaces of the first and second sacrificial patterns 342 and 344, respectively.

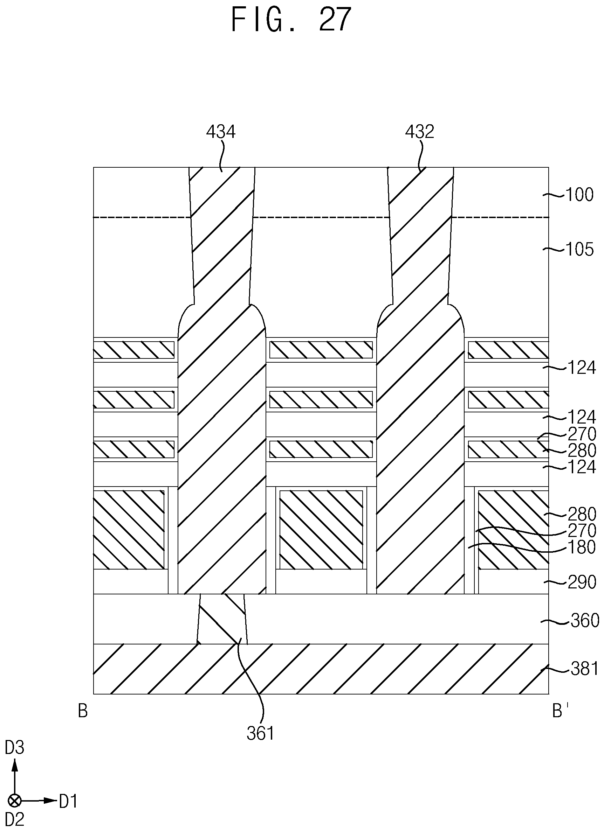

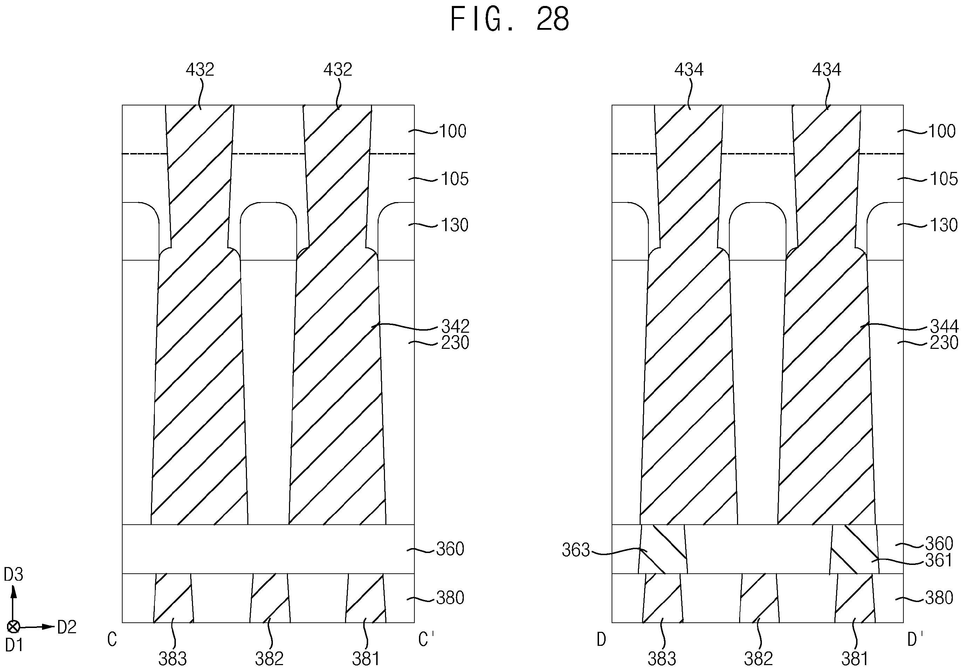

Referring to FIGS. 27 and 28, the first and second sacrificial patterns 342 and 344 may be removed through the fifth and sixth openings 402 and 404, respectively, and thus the fifth and sixth openings 402 and 404 may be expanded in the third direction D3.

In example embodiments, the first and second sacrificial patterns 342 and 344 may be removed, such as by a wet etching process. The first and second sacrificial patterns 342 and 344 may be formed of and/or include the material having an etch selectivity with respect to the materials included in the substrate 100, the semiconductor pattern 124, the gate spacer 180, and the gate insulating pattern 270, and thus, the first and second sacrificial patterns 342 and 344 may be selectively removed.

The fifth opening 402 may be expanded in the third direction D3 by removing the first sacrificial pattern 342 disposed between the first and second gate structures 302 and 304, and the sixth opening 405 may be expanded in the third direction D3 by removing the second sacrificial pattern 344 disposed between the second and third gate structures 304 and 306. In example embodiments, each of the first and second through contacts 432 and 434 may be formed by forming a conductive layer filling the expanded fifth and sixth openings 402 and 404 to a sufficient height, and performing a planarization process thereon.

Referring to FIGS. 1 to 4, with the substrate 100 remaining inverted, the fourth insulating interlayer 450 may be formed on the substrate 100, first and fourth lower vias extending through the fourth insulating interlayer 450 may be formed to contact lower surfaces of the first through contacts 432, respectively, and second and third lower vias 452 and 453 extending through the fourth insulating interlayer 450 may be formed to contact lower surfaces of the second through contacts 434, respectively.

The fifth insulating interlayer 470 may be formed on the first to fourth lower vias 451, 452, 453 and 454 and the fourth insulating interlayer 450. First to fourth lower wirings 471, 472, 473 and 474 extending through the fifth insulating interlayer 470 may be formed to contact lower surfaces of the first to fourth lower vias 451, 452, 453, and 454, respectively.

The substrate 100 may then be rotated 180 degrees again (e.g., returned to its original orientation).

In the method of manufacturing a semiconductor device, the third and fourth openings 322 and 324 extending through the first insulating interlayer 230 on the front side of the substrate 100 may be formed to expose the upper surface of the active pattern 105, and the first and second sacrificial patterns 342 and 344 may be formed in the third and fourth openings 322 and 324, respectively. The substrate 100 may be rotated by 180 degrees (e.g., inverted), the fifth and sixth openings 402 and 404 extending through the substrate 100 may be formed to expose the first and second sacrificial patterns 342 and 344, respectively, the first and second sacrificial patterns 342 and 344 may be removed though the fifth and sixth openings 402 and 404, and the first and second through contacts 432 and 434 may be formed in the expanded fifth and sixth openings 402 and 404, respectively. Each of the first and second through contacts 432 and 434 may be formed of and/or include a single material, and thus, compared to a case in which, upper and lower portions of each of the first and second through contacts 432 and 434 are formed of or include materials that differ from each other, power loss due to interfacial resistance between the upper and lower portions may be reduced.

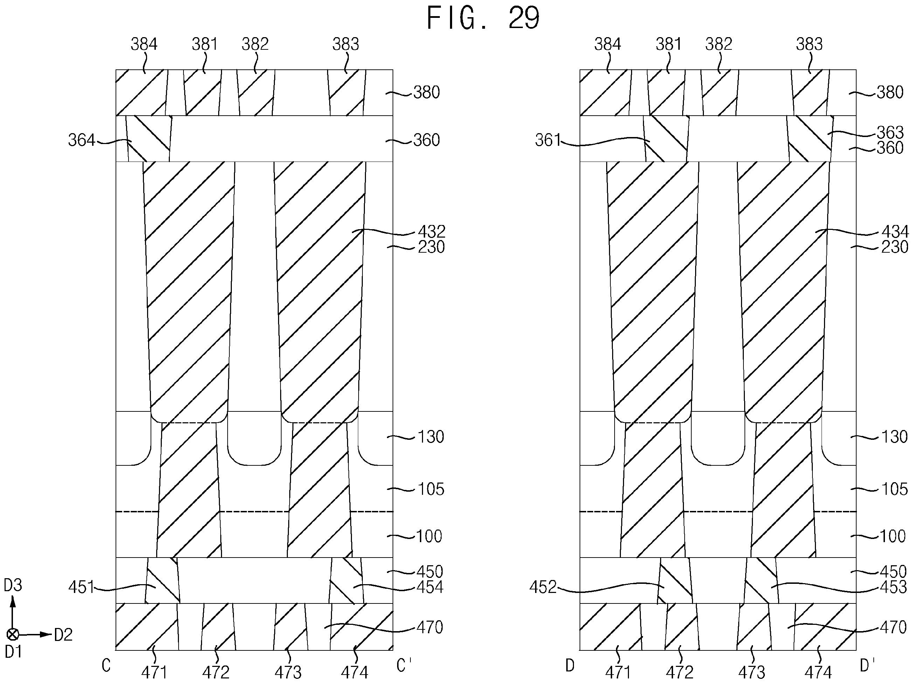

FIG. 29 is a cross-sectional view illustrating a semiconductor device in accordance with example embodiments. This semiconductor device may be substantially the same as or similar to the semiconductor device of FIGS. 1 to 4 and the description of previously described elements may be omitted. The semiconductor of FIG. 29 differs from the previous example in that a fourth upper via 364 and a fourth upper wiring 384 are included.

Referring to FIG. 29, the fourth upper via 364 may extend through the second insulating interlayer 360 to contact an upper surface of the first through contact 432, and the fourth upper wiring 384 may extend through the third insulating interlayer 380 to contact an upper surface of the fourth upper via 364. Accordingly, the fourth upper wiring 384 may be electrically connected to the first lower wiring 471 through the fourth upper via 364, the first through contact 432, and the first lower via 451. In example embodiments, the fourth upper wiring 384 may extend in the first direction D1.

In another example, the fourth upper via 364 may extend through the second insulating interlayer 360 to contact an upper surface of the second through contact 434. In this example, the fourth upper wiring 384 may be electrically connected to the fourth lower wiring 474 through the second through contact 434.

That is, in addition to the first lower wiring 471 or the second lower wiring 474 that serve as a power rail on the back side of the substrate 100, the fourth upper wiring 384, which may be electrically connected to the first lower wiring 471 or the second lower wiring 474 through the first through contact 432 or the second through contact 434, may be placed on the front side of the substrate 100. Thus, the degree of freedom in designing wiring serving as a power rail may be increased.

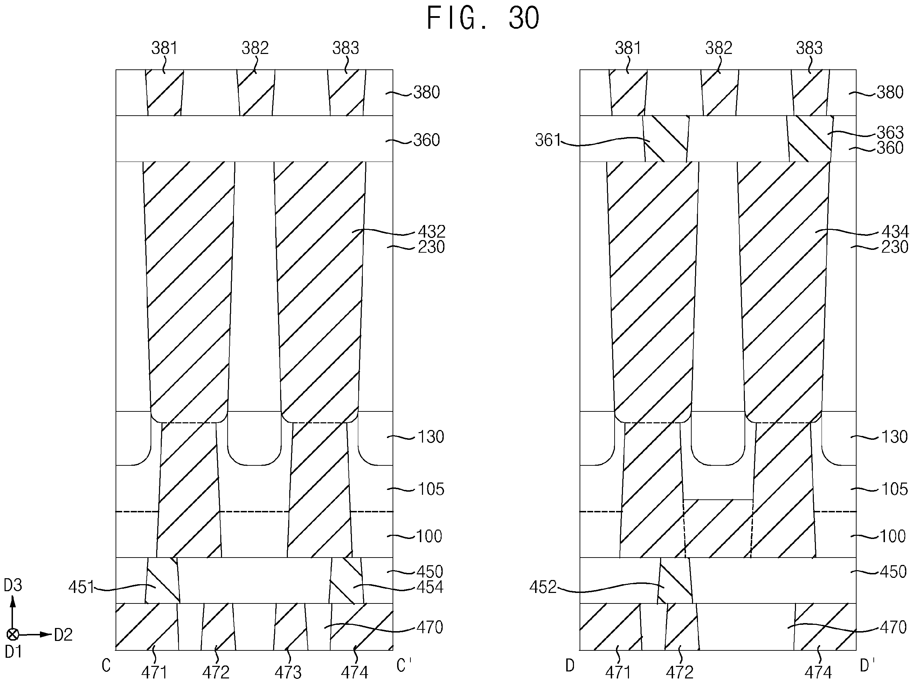

FIG. 30 is a cross-sectional view illustrating a semiconductor device in accordance with example embodiments. This semiconductor device may be substantially the same as or similar to the semiconductor device of FIGS. 1 to 4 and the description of previously described elements may be omitted. The semiconductor of FIG. 30 differs from the previous examples in that it omits the third lower via 453 and the third lower wiring 473, and the shape of the second though contacts 434 is different.

Referring to FIG. 30, a connection portion may be disposed between pairs of the second through contacts 434 that are adjacent to each other in the second direction D2 to electrically connect lower portions of the pairs of the second through contacts 434 adjacent to each other in the second direction D2. Accordingly, the pairs of the second through contacts 434 that are adjacent to each other in the second direction D2 may merge with each other.

The pairs of the second through contact 434 may be connected to the second lower wiring 472 through the second lower via 452, and thus, the third lower via 453 and the third lower wiring 473 may not be formed in this example. That is, the pairs of the second through contacts 434 spaced apart from each other in the second direction D2 may be electrically connected to each other by the connection portion, and hence, both of the second through contacts 434 of a pair may receive electrical signals from the second lower wiring 473. Accordingly, separate via or wiring for each of the second through contacts 434 of a pair is not necessary. Hence, the overall wiring may be reduced, and the wiring design of the semiconductor device may be simplified.

Additionally, the pairs of the second through contacts 434 and the connection portion therebetween may be formed of and/or include the same material so that the ones of the second through contacts 434 and the connection portions may be integrally formed. Thus, power loss that occurs at an interface between different materials may be reduced.

A connection portion may be formed between pairs of the first through contacts 432 adjacent to each other in the second direction D2 to electrically connect lower portions of the ones of the first through contacts 432 adjacent to each other in the second direction D2.

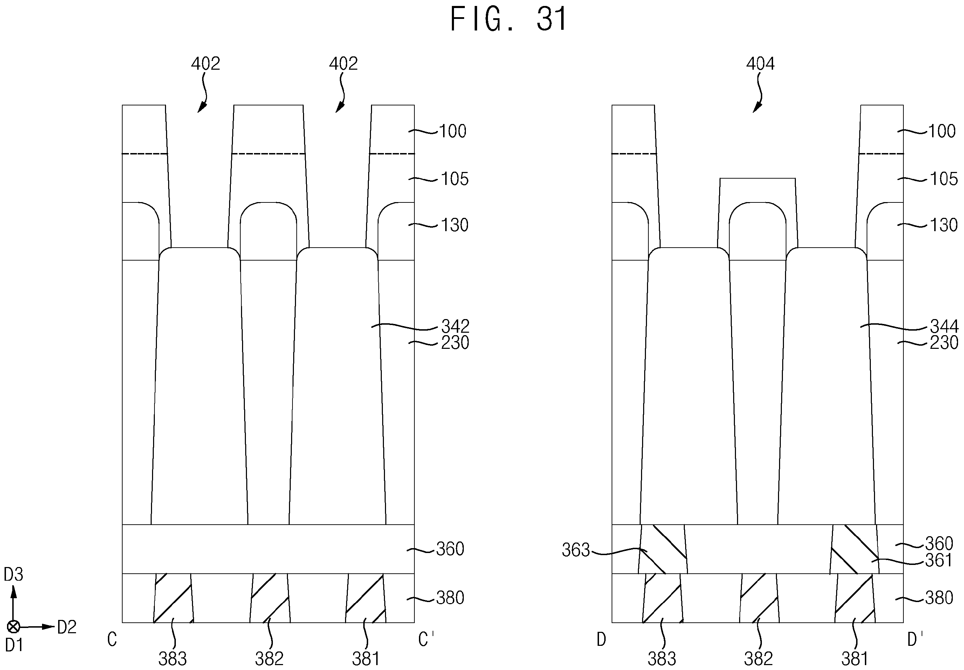

FIG. 31 includes cross-sectional views taken along line C-C' and D'-D' of corresponding plan view illustrating a method of manufacturing a semiconductor device in accordance with example embodiments. This method may be substantially the same as or similar to the semiconductor device of FIGS. 1 to 28, and thus repeated explanations may be omitted herein.

Referring to FIG. 31, after performing processes that are substantially the same as or similar to the processes described with reference to FIGS. 1 to 19, an upper portion of the first insulating interlayer 230 between two of the sixth openings 404 adjacent to each other in the second direction D2 may be partially removed. Accordingly, the sixth openings 404 adjacent to each other in the second direction D2 may be connected to each other in the second direction D2.

Thereafter, manufacturing of the semiconductor device may be completed by performing processes substantially the same as or similar to the processes described with reference to FIGS. 20 to 28.

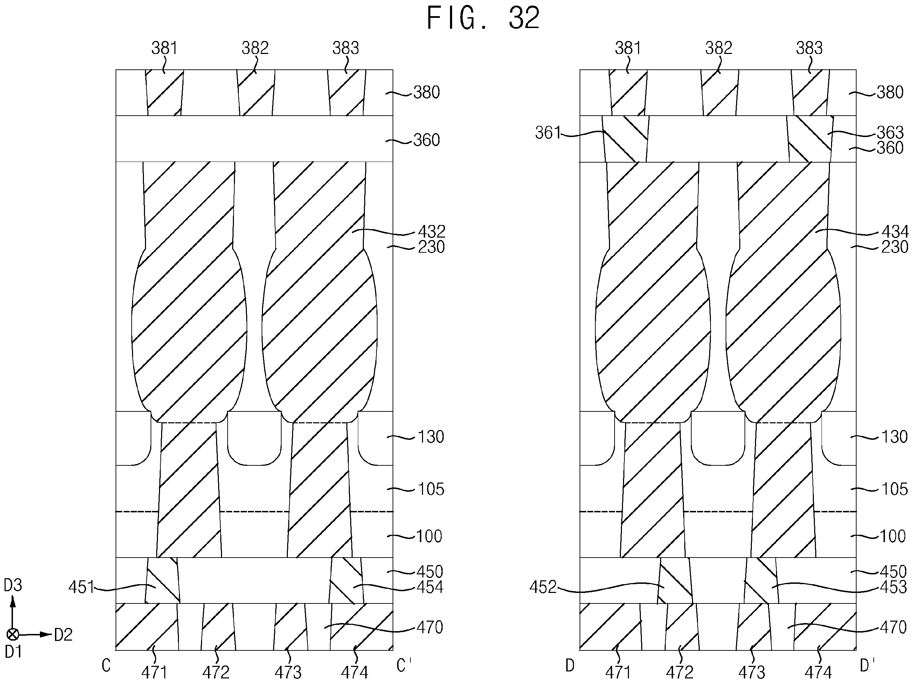

FIG. 32 is a cross-sectional view illustrating a semiconductor device in accordance with example embodiments. This semiconductor device may be substantially the same as or similar to the semiconductor device of FIGS. 1 to 4 and the description of previously described elements may be omitted. The semiconductor of FIG. 32 differs from the previous examples in the shape of the first and second through contacts 432 and 434.

Referring to FIG. 32, as the distance from the lower surface (i.e., back surface 110) of the substrate 100 in the third direction D3 increases, a width in the second direction D2 of a lower portion of each of the first and second through contacts 432 and 434 may decrease, a width in the second direction D2 of a middle portion of each of the first and second through contacts 432 and 434 may increase and thereafter decrease, and a width in the second direction D2 of an upper portion of each of the first and second through contacts 432 and 434 may increase.

For example, the central portion of each of the first and second through contacts 432 and 434 may have a convex shape and an increased volume. Since each of the first and second through contacts 432 and 434 that serves as a source/drain has an increased volume, charges within the semiconductor pattern 124 that serves as a channel may have improved mobility.

By performing an additional etching process in addition to the processes described with reference to FIG. 19, a width in the second direction D2 of the central portion of each of the third and fourth openings 322 and 324 may be expanded, and thus, the first and second through contacts 432 and 434 may further include the central portions that have a convex shape between the lower and upper portions.

A sidewall of the central portion of each of the first and second through contacts 432 and 434 in contact with the semiconductor pattern 124 may have curved surfaces, but the inventive concept may not be limited thereto. That is, if each of the first and second through contacts 432 and 434 may be formed to have a sufficient volume, the sidewall of the central portion may have, for example, an angled surface.

Additional embodiments are set out in the following clauses:
Clause 1. A semiconductor device, comprising:
   an active pattern on a substrate, the active pattern extending in a first direction parallel to an upper surface of the substrate;
   a gate structure on the active pattern, the gate structure extending in a second direction parallel to the upper surface of the substrate and crossing the first direction;
   channels spaced apart from each other in a vertical direction perpendicular to the upper surface of the substrate, each of the channels extending through the gate structure; and
   a through contact extending through the substrate and the active pattern, the through contact including a lower portion and an upper portion sequentially arranged in the vertical direction;
   wherein a width in the second direction of the lower portion of the through contact decreases as the distance in the vertical direction from a lower surface of the substrate increases, and a width in the second direction of the upper portion of the through contact increases as the distance in the vertical direction from the lower surface of the substrate increases.
Clause 2. The semiconductor device of clause 1, wherein an upper end of the lower portion of the through contact is lower than an uppermost surface of the active pattern.
Clause 3. The semiconductor device of clause 2, wherein the through contact further includes a middle portion between the lower portion and the upper portion, and a width in the second direction of the middle portion increases and then decreases as the distance in the vertical direction from the lower surface of the substrate increases.
Clause 4. The semiconductor device of any preceding clause, wherein the semiconductor device further includes:
   a lower wiring on a back side of the substrate, the lower wiring electrically connected to the through contact; and
   an upper wiring disposed on a front side of the substrate, the upper wiring electrically connected to the upper wiring.
Clause 5. The semiconductor device of any preceding clause, wherein the through contact contacts sidewalls in the first direction of the channels.
Clause 6. The semiconductor device of any preceding clause, wherein a plurality of active patterns are spaced apart from each other in the second direction,
   a plurality of gate structures are spaced apart from each other in the first direction, and
   a plurality of through contacts are spaced apart from each other in the second direction, each of the through contacts extending through a portion of the active pattern disposed between ones of the gate structures adjacent to each other in the first direction.

Although a few example embodiments have been described, those skilled in the art will readily appreciate that many modifications are possible in the example embodiments without materially departing from the novel teachings and advantages of the present inventive concept.

## Claims

1. A semiconductor device, comprising:
an active pattern on a substrate, the active pattern extending in a first direction parallel to an upper surface of the substrate;
a gate structure on the active pattern, the gate structure extending in a second direction parallel to the upper surface of the substrate and crossing the first direction;
channels spaced apart from each other in a vertical direction perpendicular to the upper surface of the substrate, each of the channels extending through the gate structure;
a through contact extending through the substrate and the active pattern in the vertical direction, an upper portion and a lower portion of the through contact connected to each other and formed of the same material;
a lower wiring on a back side of the substrate, the lower wiring electrically connected to the through contact; and
an upper wiring disposed on a front side of the substrate, the upper wiring electrically connected to the through contact.

2. The semiconductor device of claim 1, wherein the through contact contacts sidewalls of the channels in the first direction.

3. The semiconductor device of claim 1 or claim 2, wherein a width in the second direction of the lower portion of the through contact decreases as the distance in the vertical direction from a lower surface of the substrate increases, and a width in the second direction of the upper portion of the through contact increases as distance in the vertical direction from the lower surface of the substrate increases.

4. The semiconductor device of claim 3, wherein an upper end of the lower portion of the through contact is lower than an uppermost surface of the active pattern.

5. The semiconductor device of claim 4, wherein the through contact further includes a middle portion between the lower portion and the upper portion, and a width in the second direction of the middle portion increases and then decreases as the distance in the vertical direction from the lower surface of the substrate increases.

6. The semiconductor device of any preceding claim, wherein
the active pattern is a first active pattern of a plurality of first active patterns that are each spaced apart from each other in the second direction,
the gate structure is a first gate structure of a plurality of first gate structures that are each spaced apart from each other in the first direction, and
the through contact is a first through contact of a plurality of first through contacts that are spaced apart from each other in the second direction, each of the first through contacts of the plurality of first through contacts extends through a portion of a respective first active pattern between pairs of the first gate structures that are adjacent to each other in the first direction.

7. The semiconductor device of claim 6, the semiconductor further comprising:
a connection portion disposed between pairs of the first through contacts that are adjacent to each other in the second direction, the connection portion electrically connecting the pairs of the first through contacts.

8. A semiconductor device, comprising:
an active pattern on a substrate, the active pattern extending in a first direction parallel to an upper surface of the substrate;
a gate structure on the active pattern, the gate structure extending in a second direction parallel to the upper surface of the substrate and crossing the first direction;
channels spaced apart from each other in a vertical direction perpendicular to the upper surface of the substrate, each of the channels extending through the gate structure;
an insulating interlayer on the active pattern and the gate structure; and
a through contact extending through the insulating interlayer and the substrate, the through contact commonly contacting sidewalls in the first direction of the channels, and an upper portion and a lower portion of the through contact contacting each other and formed of the same material.

9. The semiconductor device of claim 8, wherein the semiconductor device further includes:
a lower wiring on a back side of the substrate, the lower wiring electrically connected to the through contact; and
an upper wiring disposed on a front side of the substrate, the upper wiring electrically connected the upper wiring.

10. The semiconductor device of claim 8 or claim 9, wherein a width in the second direction of the lower portion of the through contact decreases as distance in the vertical direction from a lower surface of the substrate increases, and a width in the second direction of the upper portion of the through contact increases as distance in the vertical direction from the lower surface of the substrate increases.

11. The semiconductor device of claim 10, wherein an upper surface of the lower portion of the through contact is lower than an uppermost surface of the active pattern.

12. The semiconductor device of claim 11, wherein the through contact further includes a middle portion between the lower portion and the upper portion, and a width in the second direction of the middle portion increases and then decreases as distance in the vertical direction from the lower surface of the substrate increases.

13. The semiconductor device of any of claims 8-12, wherein a plurality of active patterns are spaced apart from each other in the second direction,
a plurality of gate structures are spaced apart from each other in the first direction, and
a plurality of through contacts are spaced apart from each other in the second direction, each of the through contacts extending through a portion of the active pattern disposed between ones of the gate structures adjacent to each other in the first direction.

14. The semiconductor device of claim 13, the semiconductor further comprising:
a connection portion disposed between ones of the through contacts adjacent to each other in the second direction, the connection portion electrically connecting the ones of the through contacts.
